(19) Europäisches Patentamt
European Patent Office
Office européen des brevets

(11) **EP 4 489 254 A1**

(12) **EUROPEAN PATENT APPLICATION**
published in accordance with Art. 153(4) EPC

(43) Date of publication:
**08.01.2025 Bulletin 2025/02**

(21) Application number: **23924348.8**

(22) Date of filing: **07.12.2023**

(51) International Patent Classification (IPC):
*H02J 7/00* (2006.01)    *H01M 10/44* (2006.01)
*H01M 10/052* (2010.01)    *H01M 4/58* (2010.01)
*H01M 10/42* (2006.01)

(86) International application number:
**PCT/KR2023/020076**

(87) International publication number:
**WO 2024/177242 (29.08.2024 Gazette 2024/35)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **23.02.2023 KR 20230024471**

(71) Applicant: **LG Energy Solution, Ltd.
Seoul 07335 (KR)**

(72) Inventors:
• **KIM, Changha
Daejeon 34122 (KR)**
• **NAM, In Ho
Daejeon 34122 (KR)**

(74) Representative: **Plasseraud IP
104 Rue de Richelieu
CS92104
75080 Paris Cedex 02 (FR)**

(54) **BATTERY MANAGEMENT DEVICE OF BATTERY SYSTEM TO WHICH BATTERY CAN BE ADDED, AND CONTROL METHOD THEREOF**

(57)  According to embodiments of the present invention, a battery management apparatus, located in a battery system that allows for the addition of one or more new batteries, may include at least one processor; and a memory configured to store at least one instruction executed by the at least one processor.

Here, the at least one instruction may include an instruction to, upon the battery system switching to a mode for adding a new battery, determine a target state of charge (SOC) which is defined based on the state of health (SOH) of at least one pre-installed battery and the initial SOC of the new battery; an instruction to control charging and discharging of the pre-installed battery so that the SOC of the at least one pre-installed battery becomes the target SOC; and an instruction to terminate the control of charging and discharging when the SOC of the at least one pre-installed battery reaches the target SOC, for adding the new battery into the battery system.

[Figure 4]

## Description

[Technical Field]

This application claims priority to and the benefit of Korean Patent Application No.10-2023-0024471 filed in the Korean Intellectual Property Office on February 23, 2023, the entire contents of which are incorporated herein by reference.

The present invention relates to a battery management apparatus and a control method thereof, and more particularly, to a battery management apparatus located in a battery system that allows for the addition of one or more new batteries and a control method thereof.

[Background Art]

A secondary battery is a battery that can be recharged and reused even after being discharged. The secondary battery can be used as an energy source for small devices such as mobile phones, tablet PCs and vacuum cleaners, and also used as an energy source for medium and large devices such as an energy storage system (ESS) for automobiles and smart grids.

The secondary battery is applied to a system in a form of an assembly such as a battery module in which a plurality of battery cells is connected in series and parallel or a battery pack in which battery modules are connected in series and parallel according to system requirements.

Carbon materials are mainly used as an anode active material of lithium secondary batteries whereas lithium-containing cobalt oxide ($LiCoO_2$) is mainly used as a cathode active material, and lithium-containing manganese oxides ($LiMnO_2$, $LiMn_2O_4$, etc.) and lithium-containing nickel oxide ($LiNiO_2$) are also being considered.

Recently, a lithium iron phosphate ($LiFePO_4$)-based compound has been used as a cathode active material for a lithium secondary battery. A lithium iron phosphate (LFP) battery using lithium iron phosphate as a cathode active material is superior in terms of thermal stability and cost efficiency compared to other types of batteries. However, the LFP battery exhibits a plateau characteristic with a voltage plateau section in a charging characteristic curve (correlation curve between open circuit voltage and state of charge (SOC)) and a problem arises that the state of charge (SOC) cannot be accurately estimated in the plateau section.

In order to resolve the imbalance between batteries during the operation of the battery system, balancing control based on estimated values of SOC is essential. However, in the case of LFP batteries, it is difficult to accurately estimate SOC in the plateau section, so balancing control is performed only in non-flat sections (for example, a section where SOC is 90% or more or a section where SOC is 10% or less).

New batteries may be added to or replaced in the battery system due to capacity addition of the battery system or failure of a specific battery. Generally, connection of a new battery with the existing battery is carried out when the existing battery has the shipping SOC of the new battery. During the operation of the battery system after connecting a new battery, a difference in SOC between batteries occurs due to a difference in SOH (State of Health) between the existing battery and the new battery. In particular, in the case of a battery system equipped with LFP batteries, the difference in SOC between the new battery and the existing battery appears larger in the balancing control start section (for example, the section where SOC is above 90%), so unnecessary balancing control may be performed repeatedly.

Accordingly, appropriate control technology is needed to prevent unnecessary balancing control operations in a battery system that allows additional installation of new batteries.

[Detailed Description of the Invention]

[Technical Problem]

To obviate one or more problems of the related art, embodiments of the present disclosure provide a battery management apparatus capable of preventing unnecessary balancing control operations in a battery system that allows additional installation of a new battery.

To obviate one or more problems of the related art, embodiments of the present disclosure also provide a control method of the battery management apparatus.

To obviate one or more problems of the related art, embodiments of the present disclosure also provide a battery system including the battery management apparatus.

[Technical Solution]

In order to achieve the objective of the present disclosure, a battery system, which allows for the addition of one or more new batteries, may include at least one pre-installed battery; and a battery management apparatus configured to monitor status information about the battery included in the battery system and control the battery based on the status information.

Here, upon the battery system switching to a mode for adding a new battery, the battery management apparatus may determine a target state of charge (SOC) which is defined based on the state of health (SOH) of the pre-installed battery and the initial SOC of the new battery, control charging and discharging of the pre-installed battery so that the SOC of the pre-installed battery becomes the target SOC, and terminate the control of charging and discharging when the target SOC is reached.

The target SOC may be defined as a value which renders that the pre-installed battery and the new battery have the same SOC in an SOC section where balancing control is performed.

The target SOC may be calculated based on the SOH of the pre-installed battery, the initial SOC of the new battery, and an SOC at which balancing starts.

The target SOC may be calculated based on the following equation.

[Equation]

$$SOC\_target = SOC\_bal - K * (100 / SOH\_old)$$

(SOC_target is the target SOC, SOC_bal is a balancing start SOC, SOH_old is the SOH of the pre-installed battery, and K is an adjustment coefficient)

Here, the adjustment coefficient K may be defined based on a difference value between the balancing start SOC and the initial SOC of the new battery.

The new battery may be additionally installed into the battery system in a state where the pre-installed battery has the target SOC.

The battery management apparatus may start balancing control when one or more batteries reach the balancing start SOC in a charge/discharge mode of the battery system.

The pre-installed battery and the new battery may include one or more lithium iron phosphate (LFP) battery cells.

According to another embodiment of the present disclosure, a battery management apparatus, located in a battery system that allows for the addition of one or more new batteries, may include at least one processor; and a memory configured to store at least one instruction executed by the at least one processor.

Here, the at least one instruction may include an instruction to, upon the battery system switching to a mode for adding a new battery, determine a target state of charge (SOC) which is defined based on the state of health (SOH) of at least one pre-installed battery and the initial SOC of the new battery; an instruction to control charging and discharging of the pre-installed battery so that the SOC of the at least one pre-installed battery becomes the target SOC; and an instruction to terminate the control of charging and discharging when the SOC of the at least one pre-installed battery reaches the target SOC, for adding the new battery into the battery system.

The target SOC may be defined as a value which renders that the pre-installed battery and the new battery have the same SOC in an SOC section where balancing control is performed.

The target SOC may be defined based on the SOH of the pre-installed battery, the initial SOC of the new battery, and an SOC at which balancing starts.

The target SOC may be calculated based on the following equation.

[Equation]

$$SOC\_target = SOC\_bal - K * (100 / SOH\_old)$$

(SOC_target is the target SOC, SOC_bal is a balancing start SOC, SOH_old is the SOH of the pre-installed battery, and K is an adjustment coefficient)

Here, the adjustment coefficient K may be defined based on a difference value between the balancing start SOC and the initial SOC of the new battery.

The at least one instruction may further include: an instruction to, upon the battery system switching to a charge/discharge mode, monitor SOCs of the new battery and the pre-installed battery; and an instruction to initiate balancing control in the instance that one or more batteries reach a predefined balancing start SOC.

According to another embodiment of the present disclosure, a battery management method, which is performed by a battery management apparatus located in a battery system that allows for the addition of one or more new batteries, may include upon the battery system switching to a mode for adding a new battery, determining a target state of charge (SOC) which is defined based on the state of health (SOH) of at least one pre-installed battery and the initial SOC of the new battery; controlling charging and discharging of the pre-installed battery so that the SOC of the at least one pre-installed battery becomes the target SOC; and terminating the control of charging and discharging so as to add the new battery into the battery system when the SOC of the at least one pre-installed battery reaches the target SOC.

The target SOC may be defined as a value which renders that the pre-installed battery and the new battery have the same SOC in an SOC section where balancing control is performed.

The target SOC may be defined based on the SOH of the pre-installed battery, the initial SOC of the new battery, and an SOC at which balancing starts.

The target SOC may be calculated based on the following equation.

[Equation]

$$SOC\_target = SOC\_bal - K * (100 / SOH\_old)$$

(SOC_target is the target SOC, SOC_bal is a balancing start SOC, SOH_old is the SOH of the pre-installed battery, and K is an adjustment coefficient)

Here, the adjustment coefficient K may be defined based on a difference value between the balancing start SOC and the initial SOC of the new battery.

The method may further include, upon the battery system switching to a charge/discharge mode, monitoring SOCs of the new battery and the pre-installed battery; and initiating balancing control in the instance that one or more batteries reach a predefined balancing start SOC.

[Advantageous Effects]

According to the embodiment of the present invention as described above, unnecessary balancing control operations of a battery system that allows additional installation of a new battery can be prevented.

[Brief Description of the Drawings]

FIG. 1 is a block diagram of a general energy storage system.
FIG. 2 shows a charging characteristic curve of a lithium iron phosphate (LFP) battery.
FIG. 3 is a reference diagram for explaining a balancing logic of a general battery system.
FIG. 4 is a block diagram of a battery system according to embodiments of the present invention.
FIG. 5 is an operational flowchart of a control method of a battery management apparatus according to an embodiment of the present invention.
FIG. 6 is a reference diagram for explaining a process of calculating the target SOC according to embodiments of the present invention.
FIG. 7 is an operational flowchart of a control method of a battery management apparatus according to another embodiment of the present invention.
FIG. 8 is a block diagram of a battery management apparatus according to embodiments of the present invention.
120, 800: battery management apparatus
111: pre-installed battery
112: new battery

[Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a minimum unit that serves to store power and a battery module refers to an assembly in which a plurality of battery cells is electrically connected.

A battery rack refers to a system of a single structure that is assembled by connecting module units in series or in parallel, set by a battery manufacturer, which can be monitored and controlled by a battery management apparatus/system (BMS). A battery rack may include several battery modules and a battery protection unit or any other protection device.

A battery bank refers to a group of large-scale battery rack systems configured by connecting several racks in parallel. A bank BMS for a battery bank may monitor and control rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

A battery system controller (BSC) is a top-level control device that controls a battery system including a battery bank or a battery system with a multiple bank level structure.

State of charge (SOC) refers to a current state of charge of a battery, represented in percent points [%], and State of Health (SOH) may be a current condition of a battery compared to its ideal or original conditions, represented in percent points [%].

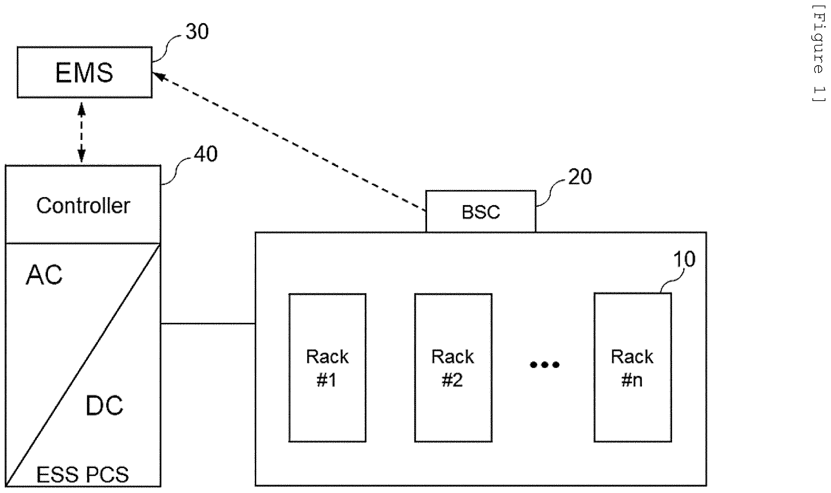

FIG. 1 is a block diagram of a general energy storage system.

In an energy storage system (ESS), typically a battery cell is a minimum unit of storing energy or power. A series/parallel combination of battery cells may form a battery module, and a plurality of battery modules may form a battery rack. In other words, a battery rack can be a minimum unit of a battery system as a series/parallel combination of battery packs. Here, depending on a device or a system in which the battery is used, a battery module may be referred to as a battery pack.

Referring to FIG. 1, a battery rack 10 may include a plurality of battery modules and a battery protection unit (BPU) or any other protection device. The battery rack can be monitored and controlled through a rack BMS(RBMS). The RBMS may monitor a current, a voltage and a temperature, among others, of each battery rack to be managed, calculate a state of charge (SOC) of the battery based on monitoring results, and control charging and discharging of the battery rack.

The battery protection unit (BPU) is a device for protecting the battery rack from an abnormal current and a fault current in the battery rack. The BPU may include a main contactor (MC), a fuse, and a circuit breaker (CB) or a disconnect switch (DS). The BPU may control a battery system rack by rack through on/off controlling the main contactor (MC) based on a control from the Rack BMS. The BPU may also protect the battery rack from a short circuit current using a fuse in the event of a short circuit. As such, a general battery system can be controlled through a protection device such as a BPU or a switchgear.

Meanwhile, a battery system controller (BSC) 20 is located in each battery section which includes a plurality of batteries, peripheral circuits, and devices to monitor and control objects such as a voltage, a current, a temperature, and a circuit breaker. The battery system controller is an uppermost control apparatus in a bank level battery system including a plurality of battery racks. The battery system controller may also be used as a control apparatus in a battery system having a plurality of bank level structures.

A power conversion system (PCS) 40 installed in each battery section performs charging/discharging based on a charge/discharge command (e.g., a charge or discharge command) from the energy management system (EMS) 30. The power conversion system (PCS) 40 may include a power conversion unit (DC/AC inverter) and a controller. The output of each BPU may be connected to the PCS 40 through a DC bus, and the PCS 40 may be connected to a power grid. In addition, the EMS(or Power Management System (PMS)) 30 may manage the overall energy storage system (ESS).

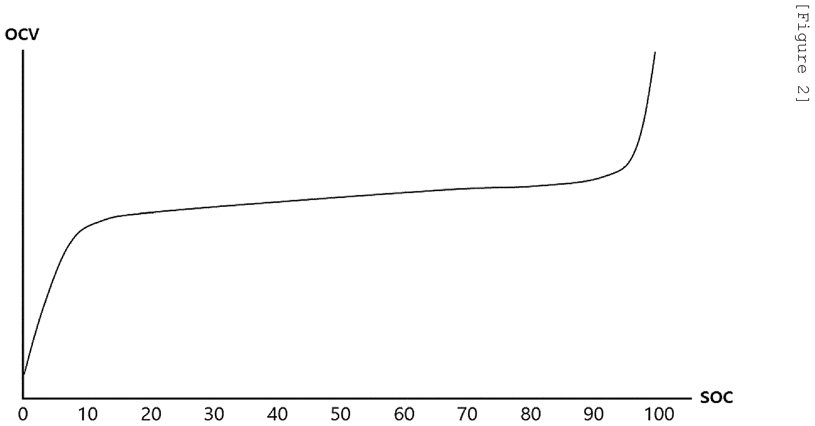

FIG. 2 shows a charging characteristic curve of a lithium iron phosphate (LFP) battery.

More specifically, FIG. 2 shows a charging characteristic curve of a lithium iron phosphate (LFP) battery using lithium iron phosphate as a cathode active material. The charging characteristic curve represents a correspondence between an open circuit voltage (OCV) and a state of charge (SOC) measured during a battery charging process.

During operation of a battery system, a battery management apparatus may perform balancing control based on SOCs of batteries. Here, a method of measuring an open-circuit voltage value of the battery and estimating the SOC of the battery based on the measured open-circuit voltage value is mainly used, in order to calculate the SOC of a battery.

Referring to FIG. 2, the charging characteristic curve of the LFP battery has a voltage plateau in the SOC range of about 10% to about 90%. In the case of an LFP battery having such a plateau characteristic, it is difficult to accurately estimate the SOC in the plateau section, accurate estimation is possible only in a non-plateau section (e.g., a section where the SOC is 90% or more, or a section where the SOC is 10% or less). Accordingly, in the case of a battery system to which LFP batteries are applied, balancing control is generally performed only in non-plateau sections.

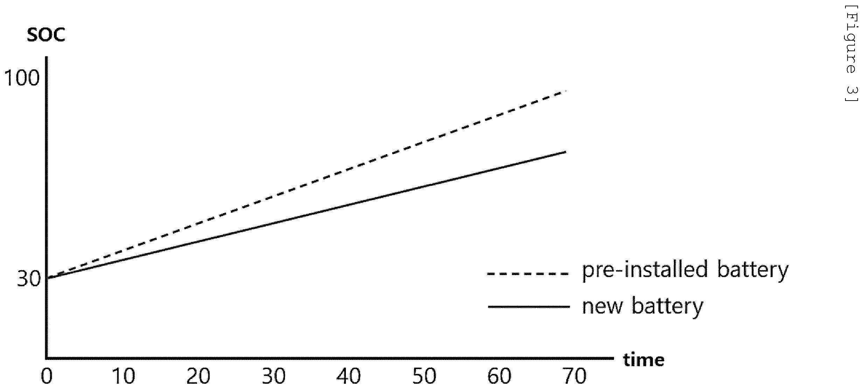

FIG. 3 is a reference diagram for explaining a balancing logic of a general battery system.

In the instance that the capacity of the battery rack 10 needs to be added or in the instance that a module needs to be replaced due to a failure of a specific battery module included in the battery rack 10 in FIG. 1, a new battery module is added or the failed module may be replaced with a new battery module.

When a new battery module needs to be connected, typically the battery system is switched into a mode for adding new batteries (e.g., maintenance mode) and the charging and discharging process continues until the SOC of pre-installed battery modules becomes the shipping SOC of new battery modules. For example, when the shipping SOC of a new battery module is 30%, the battery management apparatus may control charging and discharging of the pre-installed battery modules until the SOC of the pre-installed battery modules becomes 30%. Thereafter, when the SOC of the pre-installed battery modules becomes same as the shipping SOC of the new battery module, the new battery module is electrically connected to the pre-installed battery module.

When the battery system switches to an operating mode (e.g., charge/discharge mode) after connecting the new battery module, the new battery module and the pre-installed battery module are charged and discharged together. Here, a difference in SOC between batteries occurs due to a difference in SOH between at least one new battery modules and at least one pre-installed battery module.

Referring to FIG. 3, when the SOC of the pre-installed battery module is 30% (shipping SOC of the new battery module), a new battery module is added to the battery system and there arises SOC difference between the new battery module and the pre-installed battery module as the battery system switches to a charge/discharge mode and operates. This difference in SOC is caused by a difference in State of Health (SOH) between the new and the existing batteries and may further increase as the charging and discharging continues.

Meanwhile, in the case of a battery system to which LFP batteries are applied as shown in FIG. 2, balancing control is performed only in the non-plateau section, the pre-installed battery enters the balancing control start section (e.g., SOC 100%) first, and unnecessary balancing control may be performed repeatedly since a high imbalance condition is detected at this point.

The present invention is presented to solve this problem and relates to a battery management apparatus and a control method thereof that can prevent unnecessary balancing control operations of a battery system in which new batteries can be additionally installed.

Hereinafter, preferred embodiments according to the present invention will be described in detail with reference to the attached drawings.

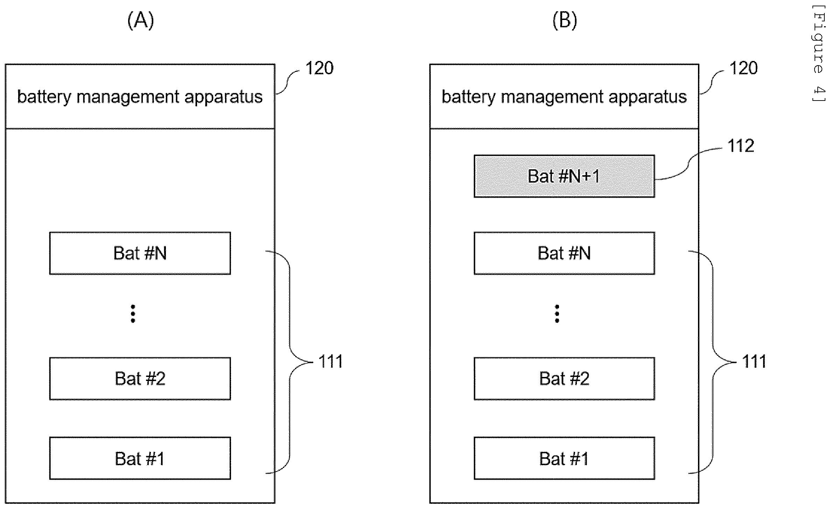

FIG. 4 is a block diagram of a battery system according to embodiments of the present invention.

Referring to FIG. 4(A), a battery system according to embodiments of the present invention may be configured to include pre-installed batteries (Bat #1 to Bat #N) 111 and a battery management apparatus 120.

The battery system according to embodiments of the present invention may be configured by additionally installing a new battery (Bat #N+1) 112, as shown in FIG. 4(B). Meanwhile, the new battery 112 according to embodiments of the present invention may mean a battery which is additionally installed to the pre-installed battery 111 or a battery which is replaced instead of a specific battery (for example, Bat #2) among the existing batteries 111 during the operation of the battery system.

In the present invention, the batteries 111 and 112 may refer to battery modules, but the scope of the present invention is not limited to these objects. In other words, the batteries 111 and 112 according to the present invention may refer to battery cells, battery racks, battery packs, or battery banks.

In an embodiment, the batteries 111 and 112 may correspond to battery cells (e.g., LFP battery cells) having at least a portion of voltage plateau section in the charging characteristic curve, or a battery assembly including one or more such battery cells.

In an embodiment, the pre-installed batteries 111 may be configured to be connected with one another in series. Here, the new battery 112 may be configured to be connected in series with the existing batteries 111 when added to the battery system.

The battery management apparatus 120 may monitor status information of the batteries 111 and 112 included in the battery system and perform predefined control operations based on the status information. For example, the battery management apparatus 120 may control charging and discharging of the battery based on battery status information and perform a predefined balancing control operation when an imbalance occurs between the batteries.

The battery management apparatus 120 may include sensors that collect status data of batteries included in the battery system or may be connected to these sensors through a network. For example, the battery management apparatus 120 may collect battery status data through a voltage sensor, a current sensor, and a temperature sensor.

The battery management apparatus 120 may calculate battery status information based on predefined state information calculation logic. For example, the battery management apparatus 120 may calculate the SOC of the battery by inputting specific status data (e.g., voltage value, etc.) collected in real time into a predefined SOC calculation logic. For another example, the battery management apparatus 120 may calculate the SOH of the battery by inputting specific status data (e.g., voltage value, current value, number of cycles, or internal resistance value, etc.) into a predefined SOH calculation logic.

When the battery system is switched to a mode for adding a new battery (e.g., maintenance mode), the battery management apparatus 120 may control charging and discharging the pre-installed battery 111 so that the pre-installed battery 111 has a predefined target SOC. Thereafter, when the SOC of the pre-installed battery 111 reaches the target SOC, the battery management apparatus 120 may terminate the control of charging and discharging to allow the new battery 112 to be connected to the pre-installed battery 111.

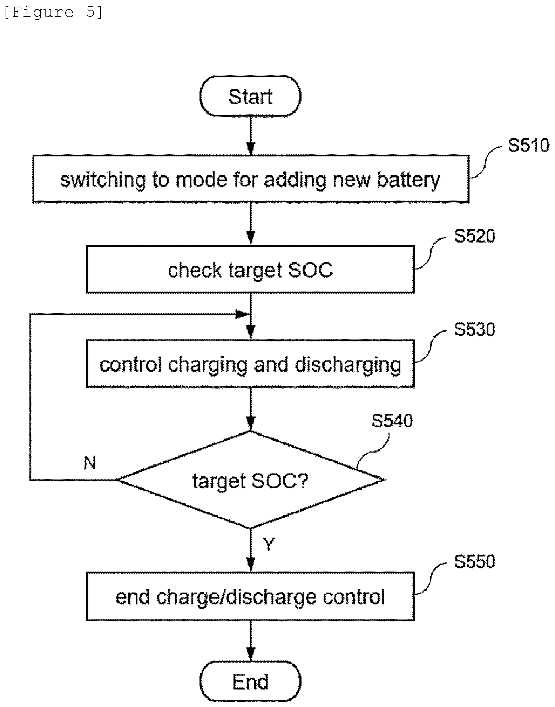

FIG. 5 is an operational flowchart of a control method of a battery management apparatus according to an embodiment of the present invention.

When the battery system switches to a mode for adding a new battery (e.g., maintenance mode) (S510), the battery management apparatus may check the target SOC of the already installed battery (S520).

The target SOC according to embodiments of the present invention may be defined based on the SOH of the pre-installed battery and the initial SOC of the new battery. Here, the target SOC may be defined as a value that renders the pre-installed battery and the new battery to have the same SOC in the SOC section where balancing control is performed.

In an embodiment, the target SOC may be defined based on the SOH of the installed battery, the initial SOC of the new battery, and the balancing start SOC. Here, the target SOC may be calculated based on Equation 1 below.

[Equation 1]

$$SOC\_target = SOC\_bal - K * (100 / SOH\_old)$$

Here, SOC_target is the target SOC, SOC_bal is the balancing start SOC, SOH_old is the SOH of the pre-installed battery, and K is an adjustment coefficient defined based on the difference value between the balancing start SOC and the initial SOC of the new battery. Meanwhile, a detailed description of the target SOC will be described later.

Thereafter, the battery management apparatus may control charging and discharging of the pre-installed battery so that the pre-installed battery has the target SOC (S530). Here, the battery management apparatus may monitor the SOC of the pre-installed battery in real time and repeatedly perform a charge-discharge process which discharges the pre-installed battery if the SOC of the pre-installed battery is higher than the target SOC and charges the pre-installed battery if the SOC of the pre-installed battery is lower than the target SOC (N in S540).

When the SOC of the pre-installed battery reaches the set target SOC (Y in S540), the battery management apparatus may end charge/discharge control to add a new battery (S550).

When the charging and discharging operation in the mode for adding a new battery is completed, the pre-installed battery has a target SOC (e.g., 12.5%) and the new battery (e.g., initial SOC 30%) may be electrically connected to the pre-installed battery in this state. Here, the target SOC may be defined as a value that ensures that the pre-installed battery and the new battery have the same SOC in the SOC section where balancing control is performed (e.g., SOC 100%), so that when the battery system is switched to the charge/discharge mode and operating, imbalance due to deviation of SOH between batteries does not occur when one or more batteries reach the balancing start SOC (for example, SOC 100%), and thus, unnecessary balancing control can be minimized.

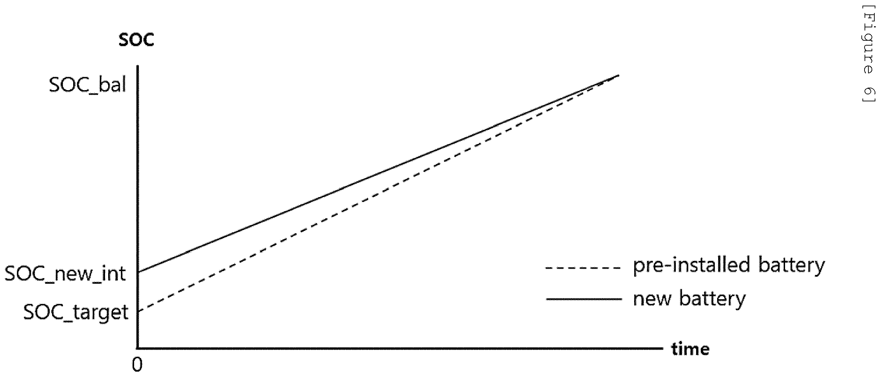

FIG. 6 is a reference diagram for explaining a process of calculating the target SOC according to embodiments of the present invention. Meanwhile, FIG. 6 shows a relationship between charge time and SOC when a new battery and the pre-installed battery are charged together with a certain charge amount after the new battery is connected to the existing battery.

Referring to FIG. 6, the SOC of the battery may be calculated based on Equation 2 below.

[Equation 2]

$$SOC\_t = SOC\_0 + (100 / SOH)*t$$

Here, SOC_t is the SOC at time t and SOC_0 is the initial SOC.

In other words, the amount of change in SOC per unit time is larger as SOH is lower and the amount of change in SOC per unit time is smaller as SOH is higher.

The SOC of each of the new battery and the pre-installed battery may be calculated based on Equation 3 and Equation 4 below.

[Equation 3]

$$SOC\_new = SOC\_new\_int + (100 / SOH\_new)*t$$

[Equation 4]

$$SOC\_old = SOC\_int\_old + (100 / SOH\_old)*t$$

Here, SOC_new_int is the initial SOC (or shipping SOC) of the new battery, SOC_int_old is the initial SOC of the existing battery, SOH_new is the SOH of the new battery, and SOH_old is the SOH of the existing battery.

The target SOC according to embodiments of the present invention may be defined as a value such that the pre-installed battery and the new battery have the same SOC at the point where balancing control is started. To calculate the target SOC with these values, each of equations 3 and 4 may be modified as follows.

[Equation 5]

$$SOC\_bal = SOC\_new\_int + (100 / SOH\_new)*t$$

[Equation 6]

$$SOC\_bal = SOC\_target + (100 / SOH\_old)*t$$

Here, SOC_target is the target SOC of the pre-installed battery and SOC_bal is the balancing start SOC.

By organizing equations 5 and 6 above, the target SOC may be calculated as follows.

[Equation 7]

$$SOC\_target = SOC\_bal - K * (100 / SOH\_old)$$

[Equation 8]

$$K = (SOC\_bal - SOC\_new\_int) * (SOH\_new /100)$$

For example, the balancing start SOC (SOC_bal) is set to 100%, the SOH (SOH_old) of the pre-installed battery is 80%, the initial SOC (SOC_new_int) of the new battery is 30%, and the SOH (SOH_new) of the new battery is 100%, the target SOC may be calculated as 12.5% (= 100 - 70*(100/80)).

For another example, the balancing start SOC (SOC_bal) is set to 90%, the SOH (SOH_old) of the pre-installed battery is 80%, the initial SOC (SOC_new_int) of the new battery is 30%, and the SOH (SOH_new) of the new battery is is 100%, the target SOC may be calculated as 15% (= 90 - 60*(100/80)).

Meanwhile, when the target SOC calculated based on the above equations has a value of 0 or less, the target SOC of the pre-installed battery may be defined as a specific value between 0 and 5.

If a new battery is additionally installed while the pre-installed battery has the target SOC according to embodiments of the present invention, the pre-installed battery even with low SOH does not reach the balancing start SOC first (see FIG. 3), and accordingly, the imbalance due to SOH deviation between batteries does not occur, and thus, unnecessary balancing control may be minimized.

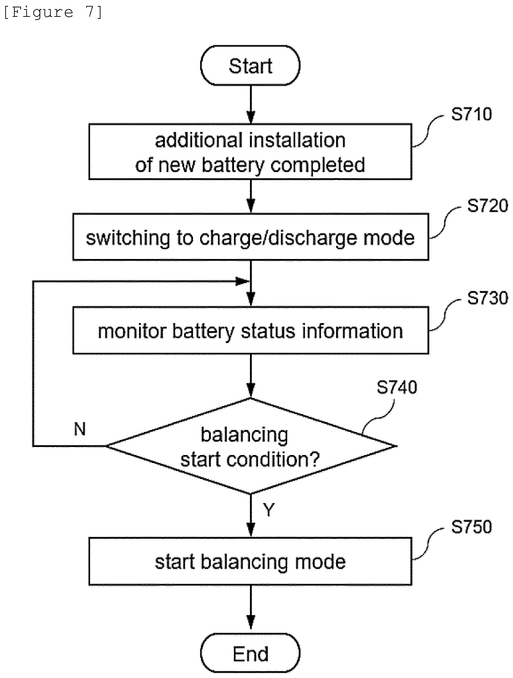

FIG. 7 is an operational flowchart of a control method of a battery management apparatus according to another embodiment of the present invention.

Once the operation in the mode for adding a new battery (FIG. 5) is completed and the additional installation of the new battery is completed (S710), the battery system may be switched to a charge/discharge mode (S720).

In the charge/discharge mode, the battery management apparatus may monitor status information of batteries (new batteries and pre-installed batteries) included in the battery system (S730).

The battery management apparatus may determine whether the balancing start condition defined based on the status information about the batteries is satisfied (S740). Here, the balancing start condition may be defined as a state in which one or more batteries reach a predefined balancing start SOC (e.g., SOC 100%).

When the balancing start condition is satisfied (Y in S740), the battery management apparatus may operate in a balancing mode to perform a predefined balancing control operation (S750).

When the balancing mode is initiated, the battery management apparatus may determine whether balancing is necessary by determining whether a predefined imbalance condition is satisfied based on the status information (e.g., voltage value or SOC) about the batteries. For example, the imbalance condition may be defined as a state in which the difference between the minimum and maximum values among the status values (voltage value or SOC) of the batteries is greater than or equal to a predefined threshold. When the imbalance condition is satisfied and balancing is determined to be necessary, the battery management apparatus may perform at least one predefined balancing control operation. Here, the balancing control operation may include an operation of reducing an imbalance between batteries by controlling a balancing circuit provided in the battery system. Meanwhile, known technologies such as passive and active balancing control methods may be applied to the balancing control method, and detailed description thereof is omitted herein since specific details regarding the balancing method and balancing circuit are not essential components of the present invention.

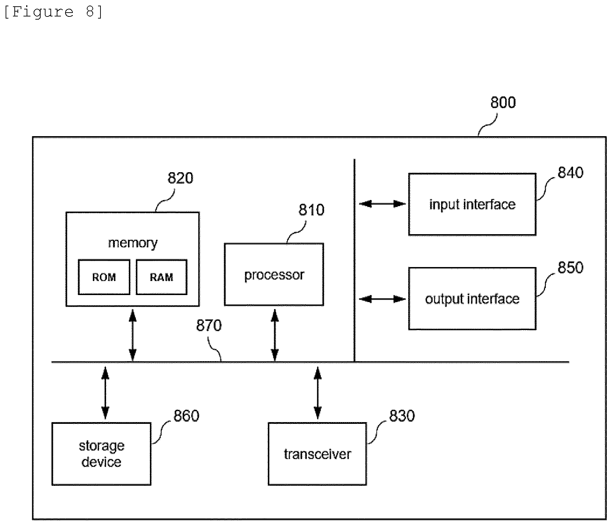

FIG. 8 is a block diagram of a battery management apparatus according to embodiments of the present invention.

The battery management apparatus 800 according to embodiments of the present invention may be located in a battery system which at least one new battery can be added and may correspond to an apparatus which manages and controls existing batteries and new batteries. For example, the battery management apparatus 800 may correspond to a rack BMS (RBMS), a battery system controller (BSC), an energy management system (EMS), or a power management system (PMS), or may be implemented by being included in any one of them.

The battery management apparatus 800 may include at least one processor 810, a memory 820 that stores at least one instruction executed by the processor, and a transceiver 830 connected to a network to perform communication.

The at least one instruction may include an instruction to, upon the battery system switching to a mode for adding a new battery, determine a target state of charge (SOC) which is defined based on the state of health (SOH) of the pre-installed battery and the initial SOC of the new battery; an instruction to control charging and discharging so that the SOC of the pre-installed battery becomes the target SOC; and an instruction to terminate the control of charging and discharging when the target SOC is reached.

The target SOC may be defined as a value which renders that the pre-installed battery and the new battery have the same SOC in an SOC section where balancing control is performed.

The target SOC may be defined based on the SOH of the pre-installed battery, the initial SOC of the new battery, and an SOC at which balancing starts.

The target SOC may be calculated based on the following equation.

[Equation]

$$SOC\_target = SOC\_bal - K * (100 / SOH\_old)$$

(SOC_target is the target SOC, SOC_bal is a balancing start SOC, SOH_old is the SOH of the pre-installed battery, and K is an adjustment coefficient)

Here, the adjustment coefficient K may be defined based on a difference value between the balancing start SOC and the initial SOC of the new battery.

The at least one instruction may further include: an instruction to, upon the battery system switching to a charge/discharge mode, monitor SOCs of the new battery and the pre-installed battery; and an instruction to initiate balancing control in the instance that one or more batteries reach a predefined balancing start SOC.

The battery management apparatus 800 may further include an input interface 840, an output interface 850, a storage device 860, and the like. Respective components included in the battery management apparatus 800 may be connected by a bus 870 to communicate with each other.

Here, the processor 810 may mean a central processing unit (CPU), a graphics processing unit (GPU), or a dedicated processor on which methods according to embodiments of the present invention are performed. The memory (or storage device) may include at least one of a volatile storage medium and a non-volatile storage medium. For example, the memory may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

**Claims**

1.  A battery system that allows for the addition of one or more new batteries, the system comprising:

    at least one pre-installed battery; and
    a battery management apparatus configured to monitor status information about the battery included in the battery system and control the battery based on the status information,
    wherein, upon the battery system switching to a mode for adding a new battery, the battery management apparatus determines a target state of charge (SOC) which is defined based on state of health (SOH) of the pre-installed battery and the initial SOC of the new battery, controls charging and discharging of the pre-installed battery so that the SOC of the pre-installed battery becomes the target SOC, and terminates the control of charging and discharging when the target SOC is reached.

2.  The battery system of claim 1, wherein the target SOC is defined as a value which renders that the pre-installed battery and the new battery have the same SOC in an SOC section where balancing control is performed.

3.  The battery system of claim 1, wherein the target SOC is calculated based on the SOH of the pre-installed battery, the initial SOC of the new battery, and an SOC at which balancing starts.

4.  The battery system of claim 1, wherein the target SOC is calculated based on the following equation,

    [Equation]

    $$\text{SOC\_target} = \text{SOC\_bal} - K * (100 / \text{SOH\_old})$$

    in which SOC_target is the target SOC, SOC_bal is a balancing start SOC, SOH_old is the SOH of the pre-installed battery, and K is an adjustment coefficient.

5.  The battery system of claim 4, wherein the adjustment coefficient K is defined based on a difference value between the balancing start SOC and the initial SOC of the new battery.

6.  The battery system of claim 1, wherein the new battery is additionally installed into the battery system in a state where the pre-installed battery has the target SOC.

7.  The battery system of claim 6, wherein the battery management apparatus starts balancing control when one or more batteries reach the balancing start SOC in a charge/discharge mode of the battery system.

8. The battery system of claim 1, wherein the pre-installed battery and the new battery include one or more lithium iron phosphate (LFP) battery cells.

9. A battery management apparatus comprised in a battery system that allows for the addition of one or more new batteries, the battery management apparatus comprising:

at least one processor; and
a memory configured to store at least one instruction executed by the at least one processor,
wherein the at least one instruction includes:

an instruction to, upon the battery system switching to a mode for adding a new battery, determine a target state of charge (SOC) which is defined based on state of health (SOH) of at least one pre-installed battery and the initial SOC of the new battery;
an instruction to control charging and discharging of the pre-installed battery so that the SOC of the at least one pre-installed battery becomes the target SOC; and
an instruction to terminate the control of charging and discharging when the SOC of the at least one pre-installed battery reaches the target SOC, for adding the new battery into the battery system.

10. The battery management apparatus of claim 9, wherein the target SOC is defined as a value which renders that the pre-installed battery and the new battery have the same SOC in an SOC section where balancing control is performed.

11. The battery management apparatus of claim 9, wherein the target SOC is defined based on the SOH of the pre-installed battery, the initial SOC of the new battery, and an SOC at which balancing starts.

12. The battery management apparatus of claim 9, wherein the target SOC is calculated based on the following equation,

[Equation]

$$SOC\_target = SOC\_bal - K * (100 / SOH\_old)$$

in which SOC_target is the target SOC, SOC_bal is a balancing start SOC, SOH_old is the SOH of the pre-installed battery, and K is an adjustment coefficient.

13. The battery management apparatus of claim 12, wherein the adjustment coefficient K is defined based on a difference value between the balancing start SOC and the initial SOC of the new battery.

14. The battery management apparatus of claim 9, wherein the at least one instruction further includes:

an instruction to, upon the battery system switching to a charge/discharge mode, monitor SOCs of the new battery and the pre-installed battery; and
an instruction to initiate balancing control in the instance that one or more batteries reach a predefined balancing start SOC.

15. A control method for a battery management apparatus comprised in a battery system that allows for the addition of one or more new batteries, the control method comprising:

upon the battery system switching to a mode for adding a new battery, determining a target state of charge (SOC) which is defined based on state of health (SOH) of at least one pre-installed battery and the initial SOC of the new battery;
controlling charging and discharging of the pre-installed battery so that the SOC of the at least one pre-installed battery becomes the target SOC; and
terminating the control of charging and discharging so as to add the new battery into the battery system when the SOC of the at least one pre-installed battery reaches the target SOC.

16. The control method of claim 15, wherein the target SOC is defined as a value which renders that the pre-installed battery and the new battery have the same SOC in an SOC section where balancing control is performed.

17. The control method of claim 15, wherein the target SOC is defined based on the SOH of the pre-installed battery, the initial SOC of the new battery, and an SOC at which balancing starts.

18. The control method of claim 15, wherein the target SOC is calculated based on the following equation,

[Equation]

$$SOC\_target = SOC\_bal - K * (100 / SOH\_old)$$

in which SOC_target is the target SOC, SOC_bal is a balancing start SOC, SOH_old is the SOH of the pre-installed battery, and K is an adjustment coefficient.

19. The control method of claim 18, wherein the adjustment coefficient K is defined based on a difference value between the balancing start SOC and the initial SOC of the new battery.

20. The control method of claim 15, further comprising:

upon the battery system switching to a charge/discharge mode,
monitoring SOCs of the new battery and the pre-installed battery; and
initiating balancing control in the instance that one or more batteries reach a predefined balancing start SOC.

[Figure 1]

[Figure 2]

[Figure 3]

(A)

(B)

battery management apparatus — 120

battery management apparatus — 120

Bat #N+1 — 112

Bat #N

Bat #N

⋮

⋮

Bat #2

Bat #2

Bat #1

Bat #1

111

111

[Figure 4]

EP 4 489 254 A1

[Figure 5]

[Figure 6]

[Figure 7]

```
                    ┌─────────┐
                    │  Start  │
                    └────┬────┘
                         │
                         ▼                          S710
        ┌────────────────────────────────┐      ⌐
        │     additional installation     │
        │    of new battery completed     │
        └────────────────┬───────────────┘
                         │                          S720
                         ▼                       ⌐
        ┌────────────────────────────────┐
        │  switching to charge/discharge mode │
        └────────────────┬───────────────┘
                         │
         ┌──────────────►│                          S730
         │               ▼                       ⌐
         │  ┌────────────────────────────────┐
         │  │  monitor battery status information │
         │  └────────────────┬───────────────┘
         │                   │
         │                   ▼            S740
         │                  ╱ ╲        ⌐
         │   N            ╱      ╲
         └──────────────╱ balancing  ╲
                        ╲ start condition? ╱
                          ╲            ╱
                            ╲ ╱
                             │ Y
                             ▼                       S750
        ┌────────────────────────────────┐      ⌐
        │       start balancing mode      │
        └────────────────┬───────────────┘
                         │
                         ▼
                    ┌─────────┐
                    │   End   │
                    └─────────┘
```

[Figure 8]

# INTERNATIONAL SEARCH REPORT

| International application No. |
|---|
| **PCT/KR2023/020076** |

| A. | CLASSIFICATION OF SUBJECT MATTER |
|---|---|
| | **H02J 7/00**(2006.01)i; **H01M 10/44**(2006.01)i; **H01M 10/052**(2010.01)i; **H01M 4/58**(2010.01)i; **H01M 10/42**(2006.01)i |

According to International Patent Classification (IPC) or to both national classification and IPC

| B. | FIELDS SEARCHED |
|---|---|

Minimum documentation searched (classification system followed by classification symbols)

H02J 7/00(2006.01); G01R 31/382(2019.01); H01M 10/42(2006.01); H01M 10/657(2014.01); H02J 7/34(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 배터리 관리 장치(battery management system), 충전 (charging), 방전(discharging), 밸런싱(balancing)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2021-093804 A (SAVE THE PLANET CO., LTD.) 17 June 2021 (2021-06-17)<br>See paragraphs [0024], [0033]-[0040], [0051]-[0064], [0090] and [0096]-[0100]; and figures 2 and 5-6. | 1-20 |
| Y | KR 10-2022-0160825 A (PMGROW CORPORATION) 06 December 2022 (2022-12-06)<br>See paragraph [0049]. | 1-20 |
| Y | KR 10-2020-0024227 A (A123 SYSTEMS, LLC) 06 March 2020 (2020-03-06)<br>See paragraphs [0012] and [0031]; and figure 1. | 8 |
| A | KR 10-2020-0128838 A (SK INNOVATION CO., LTD.) 17 November 2020 (2020-11-17)<br>See entire document. | 1-20 |
| A | KR 10-2225270 B1 (PARIDIGM. INC.) 10 March 2021 (2021-03-10)<br>See entire document. | 1-20 |

| ☐ Further documents are listed in the continuation of Box C. | ☑ See patent family annex. |
|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **26 March 2024** | **02 April 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.

**PCT/KR2023/020076**

| Patent document cited in search report | | | Publication date (day/month/year) | Patent family member(s) | | | Publication date (day/month/year) |
|---|---|---|---|---|---|---|---|
| JP | 2021-093804 | A | 17 June 2021 | JP | 2021-019400 | A | 15 February 2021 |
| | | | | JP | 7399695 | B2 | 18 December 2023 |
| | | | | JP | 7406933 | B2 | 28 December 2023 |
| | | | | US | 11509153 | B2 | 22 November 2022 |
| | | | | US | 2021-0021134 | A1 | 21 January 2021 |
| | | | | US | 2021-0021141 | A1 | 21 January 2021 |
| KR | 10-2022-0160825 | A | 06 December 2022 | None | | | |
| KR | 10-2020-0024227 | A | 06 March 2020 | CN | 110754014 | A | 04 February 2020 |
| | | | | EP | 3639320 | A1 | 22 April 2020 |
| | | | | JP | 2020-523966 | A | 06 August 2020 |
| | | | | US | 2021-0175485 | A1 | 10 June 2021 |
| | | | | WO | 2018-231573 | A1 | 20 December 2018 |
| KR | 10-2020-0128838 | A | 17 November 2020 | CN | 111916592 | A | 10 November 2020 |
| | | | | DE | 102020112455 | A1 | 12 November 2020 |
| | | | | US | 11563249 | B2 | 24 January 2023 |
| | | | | US | 2020-0358059 | A1 | 12 November 2020 |
| KR | 10-2225270 | B1 | 10 March 2021 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230024471